# EUROPEAN PATENT APPLICATION

(11) **EP 4 156 288 A1**
(43) Date of publication of application: **29.03.2023**
(21) Application number: 22184318.8
(22) Date of filing: 12.07.2022
(51) Int. Cl.: H01L 29/51, H01L 21/28

(54) **HIGH-K OR FERROELECTRIC GATE OXIDE WITH ZERO-SIO2 IL PROCESS FOR TRANSISTOR**

(30) Priority: 24.09.2021 US 202117485291
(71) Applicant: INTEL Corporation, Santa Clara, CA 95054 (US)
(72) Inventor: TUNG, I-Cheng, Hillsboro, 97124 (US); PENUMATCHA, Ashish Verma, Beaverton, 97003 (US); SUNG, Seung Hoon, Portland, 97229 (US); ATANASOV, Sarah, Beaverton, 97003 (US); KAVALIEROS, Jack T., Portland, 97229 (US); METZ, Matther, Portland, 97229 (US); AVCI, Uygar E., Portland, 97225 (US); RAMAMURTHY, Rahul, Hillsboro, 97123 (US); LIN, Chia-Ching, Portland, 97229 (US); OGUZ, Kaan, Portland, 97229 (US)
(74) Representative: Goddar, Heinz J.

(57) **Abstract**

Embodiments disclosed herein include transistors and transistor gate stacks. In an embodiment, a transistor gate stack comprises a semiconductor channel. In an embodiment, an interlayer (IL) is over the semiconductor channel. In an embodiment, the IL has a thickness of Inm or less and comprises zirconium. In an embodiment, a gate dielectric is over the IL, and a gate metal over the gate dielectric.

## Description

### TECHNICAL FIELD

Embodiments of the disclosure are in the field of semiconductor structures and processing and, in particular, to inter layer deposition for high-k or ferroelectric gate oxide stacks.

### BACKGROUND

For the past several decades, the scaling of features in integrated circuits has been a driving force behind an ever-growing semiconductor industry. Scaling to smaller and smaller features enables increased densities of functional units on the limited real estate of semiconductor chips. For example, shrinking transistor size allows for the incorporation of an increased number of memory or logic devices on a chip, lending to the fabrication of products with increased capacity. The drive for ever-more capacity, however, is not without issue. The necessity to optimize the performance of each device becomes increasingly significant.

Variability in conventional and currently known fabrication processes may limit the possibility to further extend them into the 10 nanometer node or sub-10 nanometer node range. Consequently, fabrication of the functional components needed for future technology nodes may require the introduction of new methodologies or the integration of new technologies in current fabrication processes or in place of current fabrication processes.

In the manufacture of integrated circuit devices, multi-gate transistors, such as tri-gate transistors and gate-all-around (GAA) transistors, have become more prevalent as device dimensions continue to scale down. Tri-gate transistors and GAA transistors are generally fabricated on either bulk silicon substrates or silicon-on-insulator substrates. In some instances, bulk silicon substrates are preferred due to their lower cost and compatibility with the existing high-yielding bulk silicon substrate infrastructure.

Scaling multi-gate transistors has not been without consequence, however. As the dimensions of these fundamental building blocks of microelectronic circuitry are reduced and as the sheer number of fundamental building blocks fabricated in a given region is increased, the constraints on the semiconductor processes used to fabricate these building blocks have become overwhelming.

### BRIEF DESCRIPTION OF THE DRAWINGS

Figures 1A is a cross-sectional illustration of a transistor with an interlayer (IL) over the semiconductor channel with a high-k dielectric over the IL, in accordance with an embodiment.
Figure 1B is a cross-sectional illustration of a transistor with an IL over the semiconductor channel with a ferroelectric gate oxide over the IL, in accordance with an embodiment.
Figure 2A is a cross-sectional illustration of a transistor with a semiconductor channel that is a fin with an IL over the top surface and sidewall surfaces of the fin, in accordance with an embodiment.
Figure 2B is a cross-sectional illustration of a transistor with a semiconductor channel that is a nanoribbon with an IL surrounding a perimeter of the nanoribbon, in accordance with an embodiment.
Figure 3A is a cross-sectional illustration of a semiconductor channel, in accordance with an embodiment.
Figure 3B is a cross-sectional illustration of the device after a first layer is disposed over the semiconductor channel, in accordance with an embodiment.
Figure 3C is a cross-sectional illustration of the device after a second layer is disposed over the first layer, in accordance with an embodiment.
Figure 3D is a cross-sectional illustration of the device after an annealing process results in the formation of an IL over the semiconductor channel, in accordance with an embodiment.
Figure 3E is a cross-sectional illustration of the device after a high-k dielectric is disposed over the IL, in accordance with an embodiment.
Figure 3F is a cross-sectional illustration of the device after a ferroelectric gate oxide is disposed over the IL, in accordance with an embodiment.
Figure 4A is a cross-sectional illustration of a device with a semiconductor channel that is a fin, in accordance with an embodiment.
Figure 4B is a cross-sectional illustration of the device after a first layer is disposed over the fin, in accordance with an embodiment.
Figure 4C is a cross-sectional illustration of the device after a second layer is disposed over the fin, in accordance with an embodiment.
Figure 4D is a cross-sectional illustration of the device after an annealing process results in the formation of an IL over the fin, in accordance with an embodiment.
Figure 4E is a cross-sectional illustration of the device after a high-k dielectric is disposed over the IL, in accordance with an embodiment.
Figure 4F is a cross-sectional illustration of the device after a gate metal is disposed over the high-k dielectric, in accordance with an embodiment.
Figure 5A is a cross-sectional illustration of a device with nanoribbons as the semiconductor channel, in accordance with an embodiment.
Figure 5B is a cross-sectional illustration of the device after a first layer is disposed around the nanoribbons, in accordance with an embodiment.
Figure 5C is a cross-sectional illustration of the device after a second layer is disposed around the first layer, in accordance with an embodiment.
Figure 5D is a cross-sectional illustration of the device after an annealing process results in the formation of an IL around the nanoribbons, in accordance with an embodiment.
Figure 5E is a cross-sectional illustration of the device after a high-k dielectric is disposed around the IL, in accordance with an embodiment.
Figure 5F is a cross-sectional illustration of the device after a gate metal is disposed around the high-k dielectric, in accordance with an embodiment.
Figure 6 illustrates a computing device in accordance with one implementation of an embodiment of the disclosure.
Figure 7 is an interposer implementing one or more embodiments of the disclosure.

### DESCRIPTION OF THE EMBODIMENTS

Embodiments described herein comprise inter layer deposition for high-k or ferroelectric gate oxide stacks. In the following description, numerous specific details are set forth, such as specific integration and material regimes, in order to provide a thorough understanding of embodiments of the present disclosure. It will be apparent to one skilled in the art that embodiments of the present disclosure may be practiced without these specific details. In other instances, well-known features, such as integrated circuit design layouts, are not described in detail in order to not unnecessarily obscure embodiments of the present disclosure. Furthermore, it is to be appreciated that the various embodiments shown in the Figures are illustrative representations and are not necessarily drawn to scale.

Certain terminology may also be used in the following description for the purpose of reference only, and thus are not intended to be limiting. For example, terms such as "upper", "lower", "above", "below," "bottom," and "top" refer to directions in the drawings to which reference is made. Terms such as "front", "back", "rear", and "side" describe the orientation and/or location of portions of the component within a consistent but arbitrary frame of reference which is made clear by reference to the text and the associated drawings describing the component under discussion. Such terminology may include the words specifically mentioned above, derivatives thereof, and words of similar import.

Continued device scaling for future technology nodes requires reduction in equivalent oxide thickness (EOT) of gate dielectrics. Accordingly, embodiments disclosed herein include the use of Interlayer (IL) scavenging to form an IL over the semiconductor channel. Highly precise IL thickness control in an ultra-thin IL regime (e.g., approximately 0.5nm or less) is a key technology to satisfy both performance and reliability requirements for future transistor devices (e.g., CMOS devices).

In a particular embodiment, highly precise IL thickness control in an ultra-thin IL regime can be formed in devices by a zero-SiO₂ IL monolayer process in order to form a ZrO₂ IL. Such a process involves first forming a thin SiO₂ layer over a semiconductor channel. A zirconium (Zr) monolayer is then deposited over the SiO₂ layer. An annealing process allows for the oxygen from the SiO₂ to be scavenged by the Zr to form the ZrO₂ IL. In an embodiment, ZrO₂ ILs can be used with other high-k stacks or ferroelectric gate oxide stacks in order to allow for aggressive scaling of low voltage operation devices. In other embodiments, ZrO₂ ILs may also be beneficial in front-end memory (e.g., FE-FET memory).

ILs described herein have the flexibility to be incorporated into many different transistor architectures. In one embodiment, a ZrO₂ IL may be integrated into a planar transistor device. That is, the IL may be over a planar semiconductor channel. In other embodiments, a ZrO₂ IL may be integrated into a non-planar transistor device. One such non-planar transistor device is a tri-gate or fin-FET transistor device. In such embodiments, the IL may be provided over sidewalls and a top surface of a semiconductor fin. In yet another embodiment, a ZrO₂ IL may be integrated into a nanowire, nanoribbon, or nanosheet transistor device. In such embodiments, the IL may be provided around an entire perimeter of the nanowire, nanoribbon, or nanosheet.

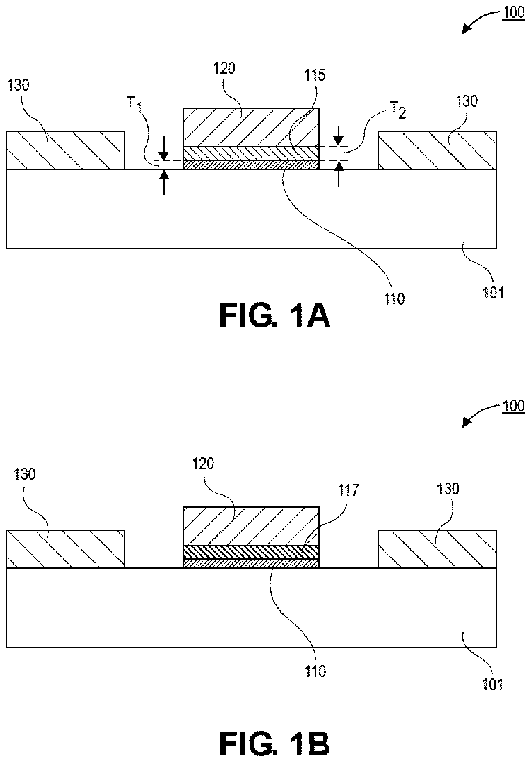

Referring now to Figure 1A, a cross-sectional illustration of a transistor device 100 is shown, in accordance with an embodiment. As shown, the transistor device 100 is a planar transistor device. That is, a semiconductor channel 101 may be a planar structure. In an embodiment, the semiconductor channel 101 may comprise any suitable semiconductor material. In an embodiment, the semiconductor channel 101 may be an integral part of an underlying semiconductor substrate. The underlying semiconductor substrate may be a general workpiece object used to manufacture integrated circuits. The semiconductor substrate often includes a wafer or other piece of silicon or another semiconductor material. Suitable semiconductor substrates include, but are not limited to, single crystal silicon, polycrystalline silicon and silicon on insulator (SOI), as well as similar substrates formed of other semiconductor materials, such as substrates including germanium, carbon, or group III-V materials.

In an embodiment, a source contact 130 and a drain contact 130 (sometimes referred together collectively as source/drain contacts 130) are provided on opposite ends of the semiconductor channel 101. The source/drain contacts 130 may comprise a wide range of materials, such as polysilicon, silicon nitride, silicon carbide, or various suitable metals or metal alloys, such as aluminum (Al), tungsten (W), titanium (Ti), tantalum (Ta), copper (Cu), titanium nitride (TiN), or tantalum nitride (TaN), for example. In an embodiment, the semiconductor material below the source/drain contacts 130 may be heavily doped. For example, a dopant concentration below the source/drain contacts 130 may be higher than a dopant concentration below the gate metal 120.

In an embodiment, a gate structure is provided between the source/drain contacts 130. In an embodiment, the gate structure comprises an interlayer (IL) 110. In a particular embodiment, the IL 110 comprises zirconium (Zr) and oxygen (O). For example, the IL 110 may comprise ZrO₂. In an embodiment, the IL 110 may have a first thickness T₁. In an embodiment, the first thickness T₁ may be approximately 1nm or smaller, or approximately 0.5 nm or smaller. As used herein, "approximately" may refer to a value within 10% of the stated value. For example, approximately 1nm may refer to a range include 0.9nm to 1.1nm.

In an embodiment, a gate dielectric 115 may be provided over the IL 110. The gate dielectric 115 may have a second thickness T₂. In an embodiment, the second thickness T₂ may be greater than the first thickness T₁. For example, the second thickness T₂ may be 5nm or less in some embodiments. In an embodiment, the gate dielectric 115 may comprise a high-k dielectric material. As used herein, "high-k" may refer to a dielectric constant equal to or larger than the dielectric constant of silicon dioxide. Examples of high-k gate dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. While specific examples of oxides are provided, it is to be appreciated that any high-k dielectric, such as nitrides, may also be used. Furthermore, multiple different materials may be used in combination in some embodiments. In some embodiments, an annealing process may be carried out on the gate dielectric 115 to improve its quality when a high-k material is used.

In an embodiment, a gate metal 120 may be provide over the gate dielectric 115. In some embodiments, the gate metal 120 may comprise a workfunction metal. When the gate metal 120 will serve as an N-type workfunction metal, the gate metal 120 preferably has a workfunction that is between about 3.9 eV and about 4.2 eV. N-type materials that may be used to form the gate metal 120 include, but are not limited to, hafnium, zirconium, titanium, tantalum, aluminum, and metal carbides that include these elements, i.e., titanium carbide, zirconium carbide, tantalum carbide, hafnium carbide and aluminum carbide. When the gate metal 120 will serve as a P-type workfunction metal, the gate metal 120 preferable has a workfunction that is between about 4.9 eV and about 5.2 eV. P-type materials that may be used to form the gate metal 120 include, but are not limited to, ruthenium, palladium, platinum, cobalt, nickel, and conductive metal oxides, e.g., ruthenium oxide. In an embodiment, the gate metal 120 may also include a fill metal above the workfunction metal. For example, the fill metal may comprise tungsten or the like.

Referring now to Figure 1B, a cross-sectional illustration of a transistor 100 is shown in accordance with an additional embodiment. In an embodiment, the transistor 100 in Figure 1B may be substantially similar to the transistor 100 in Figure 1A, with the exception of the structure of the gate stack. Instead of having a gate dielectric 115, such as a high-k dielectric, the transistor 100 in Figure 1B includes a ferroelectric gate oxide 117. In an embodiment, the ferroelectric gate oxide 117 may have a thickness that is greater than a thickness of the IL 110. For example, the ferroelectric gate oxide 117 may have a thickness that is approximately 5nm or less.

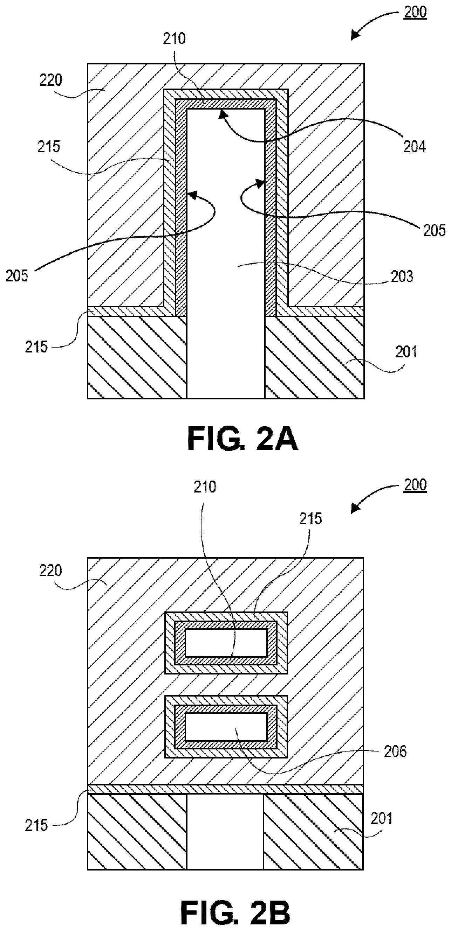

While a planar transistor 100 is shown in Figures 1A-1B, it is to be appreciated that non-planar transistor architectures may also include ILs that comprise zirconium and oxygen. For example, in Figure 2A a tri-gate structure is shown, and in Figure 2B a gate-all-around (GAA) structure is shown, in accordance with various embodiments.

Referring now to Figure 2A, a cross-sectional illustration of a non-planar transistor device 200 is shown, in accordance with an embodiment. In an embodiment, the transistor device 200 comprises a shallow trench isolation (STI) 201 with a semiconductor fin 203 passing through the STI 201. The fin 203 may have a top surfaces 204, and sidewall surfaces 205. In the illustrated embodiment, the sidewalls are shown as being substantially vertical. However, it is to be appreciated that the sidewalls 205 may be tapered in some embodiments. That is, a top end of the fin 203 may be narrower than a bottom of the fin 203 in some embodiments.

In an embodiment, an IL 210 is provided over the fin 203. For example, the IL 210 may be u-shaped and be in direct contact with the top surface 204 and the sidewall surfaces 205 of the fin 203. In an embodiment, a thickness of the IL 210 may be approximately 1nm or less, or approximately 0.5nm or less. In an embodiment, the IL 210 may comprise zirconium and oxygen (e.g., ZrO₂). In an embodiment, a gate dielectric 215 is provided over the surface of the IL 210. In an embodiment, the gate dielectric 215 may be a high-k dielectric. For example, the gate dielectric 215 may be include any of the high-k materials described above. However, in other embodiments a ferroelectric gate oxide may replace the gate dielectric 215.

In an embodiment, a gate metal 220 is provided over the gate dielectric 215. The gate metal 220 may include a workfunction metal and a fill metal. In an embodiment, the workfunction metal and the fill metal may include any of the workfunction or fill metals described in greater detail above. As shown, the gate metal 220 is around the top surface 204 and the sidewall surfaces 205. As such, three surfaces of the fin 203 are controlled to provide a tri-gate control of the transistor 200.

Referring now to Figure 2B, a cross-sectional illustration of a non-planar transistor device 200 is shown, in accordance with an additional embodiment. In an embodiment, the transistor device 200 comprises an STI 201 and one or more channels 206. In an embodiment, the channels 206 are raised above the STI 201. While shown as floating in the cross-section shown in Figure 2B, it is to be appreciated that the channels 206 are mechanically coupled to source/drain regions that are out of the plane of Figure 2B. In the illustrated embodiment, the channels 206 are shown as being nanoribbons. However, it is to be appreciated that the channels 206 may be nanowires, nanosheets, or any other GAA architecture.

In an embodiment, an IL 210 is provided around an entire perimeter of the channels 206. In an embodiment, the IL 210 has a thickness that is approximately 1nm or less, or approximately 0.5nm or less. The IL 210 may comprise zirconium and oxygen (e.g., ZrO₂). In an embodiment, a gate dielectric 215 is provided over the surface of the IL 210. In an embodiment, the gate dielectric 215 may be a high-k dielectric. For example, the gate dielectric 215 may be include any of the high-k materials described above. However, in other embodiments a ferroelectric gate oxide may replace the gate dielectric 215.

In an embodiment, a gate metal 220 is provided over the gate dielectric 215. The gate metal 220 may include a workfunction metal and a fill metal. In an embodiment, the workfunction metal and the fill metal may include any of the workfunction or fill metals described in greater detail above. As shown, the gate metal 220 wraps entirely around a perimeter of the channels 206. As such, gate control is provided all around the channels 206.

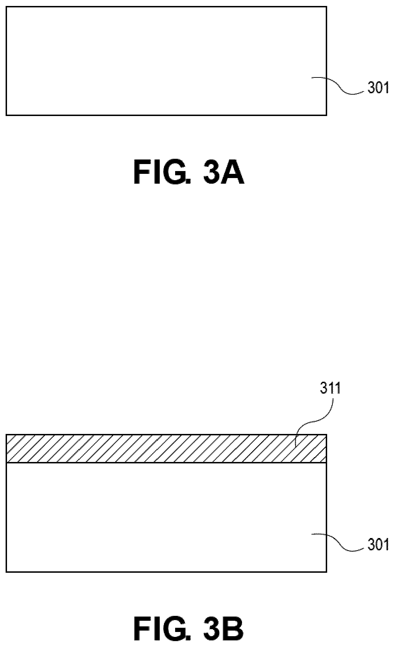

Referring now to Figures 3A-3F, a series of cross-sectional illustrations depicting a process for forming a transistor device with an IL between the semiconductor channel and the gate dielectric or ferroelectric gate oxide is shown, in accordance with an embodiment. The transistor device fabricated in Figures 3A-3F is a planar transistor device similar to the transistor devices 100 described in greater detail above.

Referring now to Figure 3A, a cross-sectional illustration of a semiconductor channel 301 is shown, in accordance with an embodiment. In an embodiment, the semiconductor channel 301 may be any suitable semiconductor material. In a particular embodiment, the semiconductor channel 301 comprises silicon. In an embodiment, the semiconductor channel 301 may be cleaned with various etching chemistries in order to provide a pristine top surface. For example, a piranha and buffered oxide etch (BOE) may be used to clean the surface of the semiconductor channel 301.

Referring now to Figure 3B, a cross-sectional illustration of the device after a first layer 311 is disposed over the semiconductor channel 301 is shown, in accordance with an embodiment. In an embodiment, the first layer 311 may comprise silicon and oxygen. For example, the first layer 311 may be a silicon oxide, such as SiO₂. In an embodiment, the first layer 311 may be formed with any suitable deposition or growth process. For example, a UV ozone treatment may be used to produce a clean, thin SiO₂ layer over the semiconductor channel 301. In a particular embodiment, a thickness of the first layer 311 may be approximately 1nm or less, or approximately 0.5nm or less.

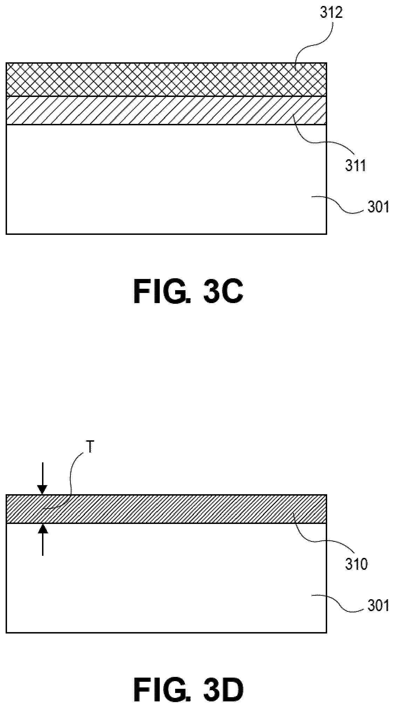

Referring now to Figure 3C, a cross-sectional illustration of the device after a second layer 312 is deposited over the first layer 311 is shown, in accordance with an embodiment. In an embodiment, the second layer 312 may comprise a material that will scavenge oxygen from the first layer 311. In a particular embodiment, the second layer 312 comprises zirconium. In some embodiments, the second layer 312 may be described as a single molar layer. That is, a single atomic layer of zirconium may be provided over the first layer 311. In other embodiments, multiple atomic layers of zirconium are provided over the first layer 311. In some embodiments, a thickness of the second layer 312 may be approximately 1nm or less, or approximately 0.5nm or less.

Referring now to Figure 3D, a cross-sectional illustration of the device after an annealing process is implemented is shown, in accordance with an embodiment. In an embodiment, the annealing process results in the second layer 312 scavenging oxygen from the first layer 311 to form a metal oxide IL 310. In an embodiment, with a SiO₂ first layer 311 and a Zr second layer 312, the resulting IL 310 may comprise zirconium and oxygen (e.g., ZrO₂). In an embodiment, the annealing process may be implemented at a temperature of approximately 750°C or greater, or approximately 870°C or greater. In an embodiment, the resulting IL 310 may have a thickness that is approximately 1nm or less, or approximately 0.5nm or less.

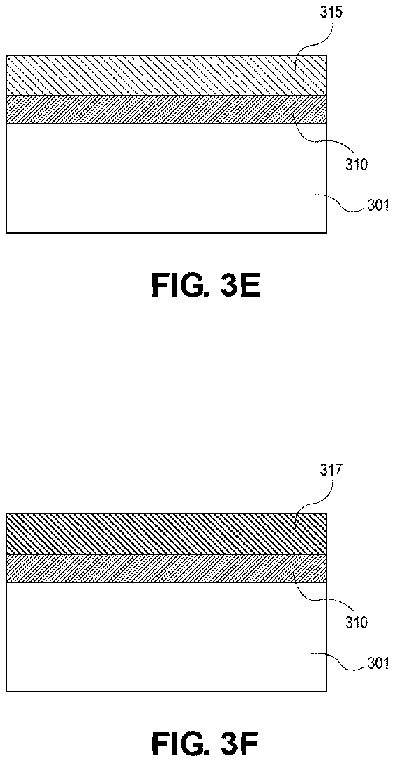

Referring now to Figure 3E, a cross-sectional illustration of the device after a gate dielectric 315 is deposited over the IL 310 is shown, in accordance with an embodiment. In an embodiment, the gate dielectric 315 may be a high-k dielectric, such as the high-k materials described in greater detail above. In an embodiment, a thickness of the gate dielectric 315 may be greater than the thickness of the IL 310. In an a particular embodiment, the thickness of the gate dielectric 315 may be approximately 5nm or less. After formation of the gate dielectric 315, a gate metal (not shown) may be deposited over the gate dielectric 315.

Referring now to Figure 3F, an alternative embodiment is shown. Instead of a gate dielectric 315, the device includes a ferroelectric gate oxide 317 that is deposited over the IL 310. In an embodiment, a thickness of the ferroelectric gate oxide 317 may be thicker than the IL 310. For example, the thickness of the ferroelectric gate oxide 317 may be approximately 5nm or less. After formation of the ferroelectric gate oxide 317, a gate metal (not shown) may be deposited over the ferroelectric gate oxide 317.

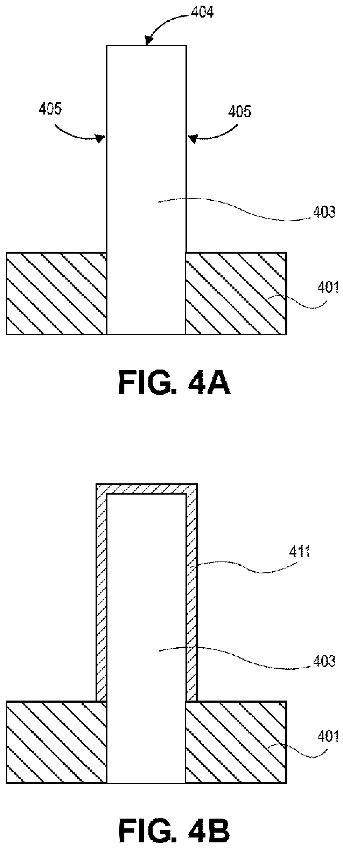

Referring now to Figures 4A-4F, a series of cross-sectional illustrations depicting a process for forming a non-planar transistor device with an IL is shown, in accordance with an embodiment. In an embodiment, the transistor in Figures 4A-4F is a tri-gate transistor device similar to the transistor device 200 in Figure 2A.

Referring now to Figure 4A, a cross-sectional illustration of a STI 401 with a fin 403 passing through the STI 401 is shown, in accordance with an embodiment. In an embodiment, the fin 403 may include any suitable semiconductor material, and the STI 401 may be an insulator. For example, the fin 403 may comprise silicon and the STI 401 may comprise an oxide. In an embodiment, the fin 403 extends up through the STI 401. The fin 403 may comprise sidewall surfaces 405 and a top surface 404. While shown as being substantially rectangular, it is to be appreciated that the cross-section of the fin 403 may be tapered with a bottom that is wider than a top. Additionally, corners between the sidewalls 405 and the top surface 404 may be rounded in some instances. In an embodiment, the semiconductor fin 403 may be cleaned with various etching chemistries in order to provide a pristine surface. For example, a piranha and BOE chemistry may be used to clean the surfaces of the semiconductor fin 403.

Referring now to Figure 4B, a cross-sectional illustration of the device after a first layer 411 is disposed over the fin 403 is shown, in accordance with an embodiment. In an embodiment, the first layer 411 may be over and in contact with the sidewall surfaces 405 and the top surface 404 of the fin 403. In an embodiment, the first layer 411 may comprise silicon and oxygen. For example, the first layer 411 may be a silicon oxide, such as SiO₂. In an embodiment, the first layer 411 may be formed with any suitable deposition or growth process. For example, a UV ozone treatment may be used to produce a clean, thin SiO₂ layer over the semiconductor fin 403. In a particular embodiment, a thickness of the first layer 411 may be approximately 1nm or less, or approximately 0.5nm or less.

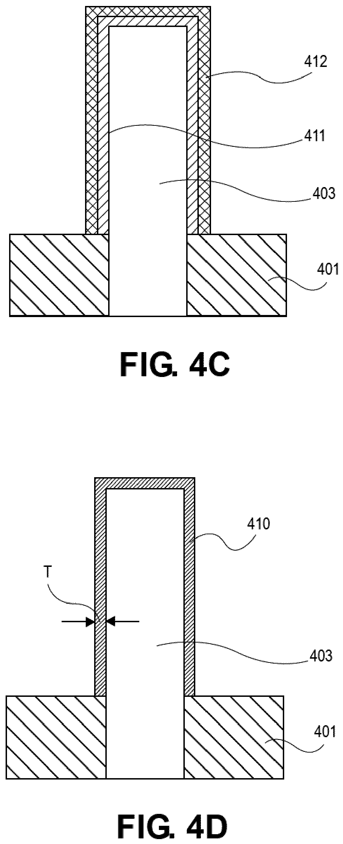

Referring now to Figure 4C, a cross-sectional illustration of the device after a second layer 412 is deposited over the first layer 411 is shown, in accordance with an embodiment. In an embodiment, the second layer 412 may comprise a material that will scavenge oxygen from the first layer 411. In a particular embodiment, the second layer 412 comprises zirconium. In some embodiments, the second layer 412 may be described as a single molar layer. That is, a single atomic layer of zirconium may be provided over the first layer 411. In other embodiments, multiple atomic layers of zirconium are provided over the first layer 411. In some embodiments, a thickness of the second layer 412 may be approximately 1nm or less, or approximately 0.5nm or less.

Referring now to Figure 4D, a cross-sectional illustration of the device after an annealing process is implemented is shown, in accordance with an embodiment. In an embodiment, the annealing process results in the second layer 412 scavenging oxygen from the first layer 411 to form a metal oxide IL 410. In an embodiment, with a SiO₂ first layer 411 and a Zr second layer 412, the resulting IL 410 may comprise zirconium and oxygen (e.g., ZrO₂). In an embodiment, the annealing process may be implemented at a temperature of approximately 750°C or greater, or approximately 870°C or greater. In an embodiment, the resulting IL 410 may have a thickness T that is approximately 1nm or less, or approximately 0.5nm or less.

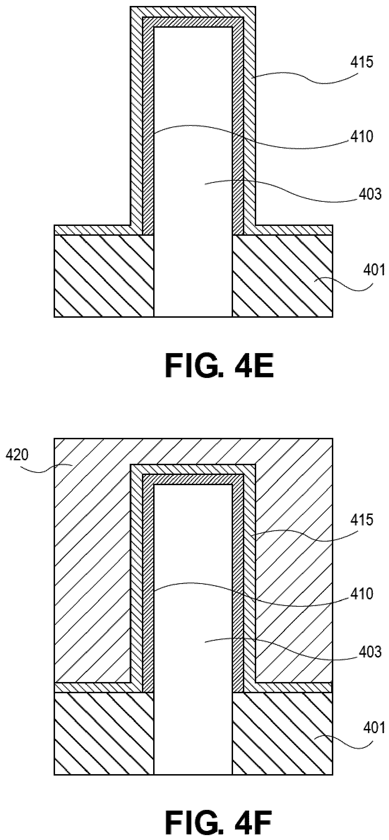

Referring now to Figure 4E, a cross-sectional illustration of the device after a gate dielectric 415 is provided over the IL 410 is shown, in accordance with an embodiment. In an embodiment, the gate dielectric 415 may be a high-k dielectric, such as the high-k materials described in greater detail above. In an embodiment, a thickness of the gate dielectric 415 may be greater than the thickness of the IL 410. In an a particular embodiment, the thickness of the gate dielectric 415 may be approximately 5nm or less. While a gate dielectric 415 is shown in Figure 4E, it is to be appreciated that a ferroelectric gate oxide may be formed over the IL 410 in an alternative embodiment.

Referring now to Figure 4F, a cross-sectional illustration of the device after a gate metal 420 is disposed over the gate dielectric 415 is shown, in accordance with an embodiment. In an embodiment, the gate metal 420 may comprise a workfunction metal, such as one of the workfunction metals described in detail above. In an embodiment, a fill metal may be provided over the gate metal 420.

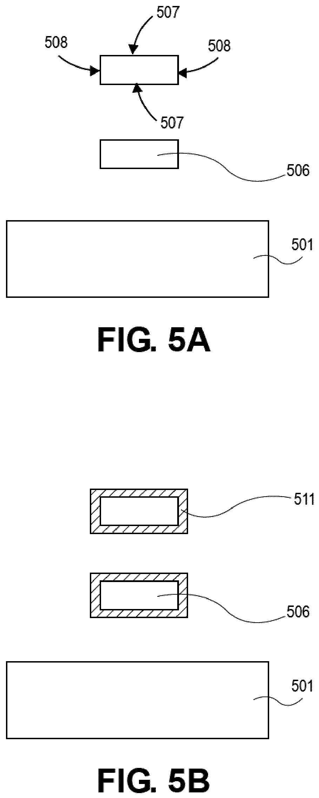

Referring now to Figures 5A-5F, a series of cross-sectional illustrations depicting a process for forming a non-planar transistor device with an IL is shown, in accordance with an embodiment. In an embodiment, the transistor in Figures 5A-5F is a GAA transistor device similar to the transistor device 200 in Figure 2B.

Referring now to Figure 5A, a cross-sectional illustration of a semiconductor substrate 501 with a semiconductor channels 506 is shown, in accordance with an embodiment. In an embodiment, the channels 506 and the substrate 501 may include any suitable semiconductor material. For example, the substrate 501 and the channels 506 may comprise silicon. In an embodiment, two channels 506 are shown, but it is to be appreciated that any number of channels may be included. While shown as floating in Figure 5A, it is to be appreciated that ends of the channels 506 are mechanically coupled to source/drain regions out of the plane of Figure 5A. In the illustrated embodiment, the channels 506 are shown with a nanoribbon form factor. However, it is to be appreciated that the form factor may include nanowires, nanosheets, or any other GAA architecture. In an embodiment, the channels 506 may include top and bottom surfaces 507 and sidewall surfaces 508. While shown with sharp ninety degree corners, it is to be appreciated that the corners may be rounded in some embodiments. In an embodiment, the semiconductor channels 506 may be cleaned with various etching chemistries in order to provide a pristine surface. For example, a piranha and BOE chemistry may be used to clean the surfaces of channels 506.

Referring now to Figure 5B, a cross-sectional illustration of the device after a first layer 511 is disposed over the channels 506 is shown, in accordance with an embodiment. In an embodiment, the first layer 511 may be over and in contact with the sidewall surfaces 508 and the top and bottom surfaces 507 of the channels 506. In an embodiment, the first layer 511 may comprise silicon and oxygen. For example, the first layer 511 may be a silicon oxide, such as SiO₂. In an embodiment, the first layer 511 may be formed with any suitable deposition or growth process. For example, a UV ozone treatment may be used to produce a clean, thin SiO₂ layer over the channels 506. In a particular embodiment, a thickness of the first layer 511 may be approximately 1nm or less, or approximately 0.5nm or less.

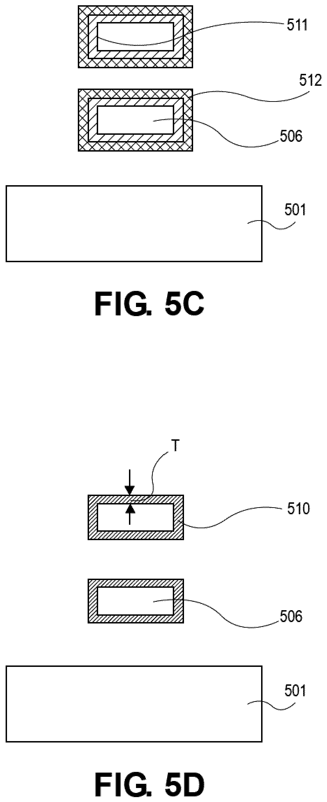

Referring now to Figure 5C, a cross-sectional illustration of the device after a second layer 512 is deposited over the first layer 511 is shown, in accordance with an embodiment. In an embodiment, the second layer 512 may comprise a material that will scavenge oxygen from the first layer 511. In a particular embodiment, the second layer 512 comprises zirconium. In some embodiments, the second layer 512 may be described as a single molar layer. That is, a single atomic layer of zirconium may be provided over the first layer 511. In other embodiments, multiple atomic layers of zirconium are provided over the first layer 511. In some embodiments, a thickness of the second layer 512 may be approximately 1nm or less, or approximately 0.5nm or less.

Referring now to Figure 5D, a cross-sectional illustration of the device after an annealing process is implemented is shown, in accordance with an embodiment. In an embodiment, the annealing process results in the second layer 512 scavenging oxygen from the first layer 511 to form a metal oxide IL 510. In an embodiment, with a SiO₂ first layer 511 and a Zr second layer 512, the resulting IL 510 may comprise zirconium and oxygen (e.g., ZrO₂). In an embodiment, the annealing process may be implemented at a temperature of approximately 750°C or greater, or approximately 870°C or greater. In an embodiment, the resulting IL 510 may have a thickness T that is approximately 1nm or less, or approximately 0.5nm or less.

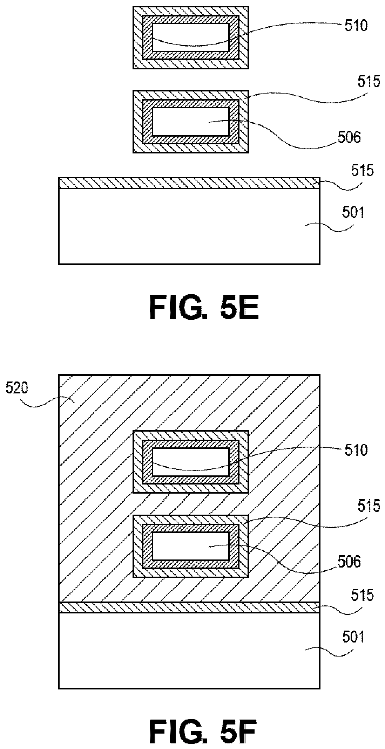

Referring now to Figure 5E, a cross-sectional illustration of the device after a gate dielectric 515 is provided over the IL 510 is shown, in accordance with an embodiment. In an embodiment, the gate dielectric 515 may be a high-k dielectric, such as the high-k materials described in greater detail above. In an embodiment, a thickness of the gate dielectric 515 may be greater than the thickness of the IL 510. In an a particular embodiment, the thickness of the gate dielectric 515 may be approximately 5nm or less. While a gate dielectric 515 is shown in Figure 5E, it is to be appreciated that a ferroelectric gate oxide may be formed over the IL 510 in an alternative embodiment.

Referring now to Figure 5F, a cross-sectional illustration of the device after a gate metal 520 is disposed over the gate dielectric 515 is shown, in accordance with an embodiment. In an embodiment, the gate metal 520 may comprise a workfunction metal, such as one of the workfunction metals described in detail above. In an embodiment, a fill metal may be provided over the gate metal 520.

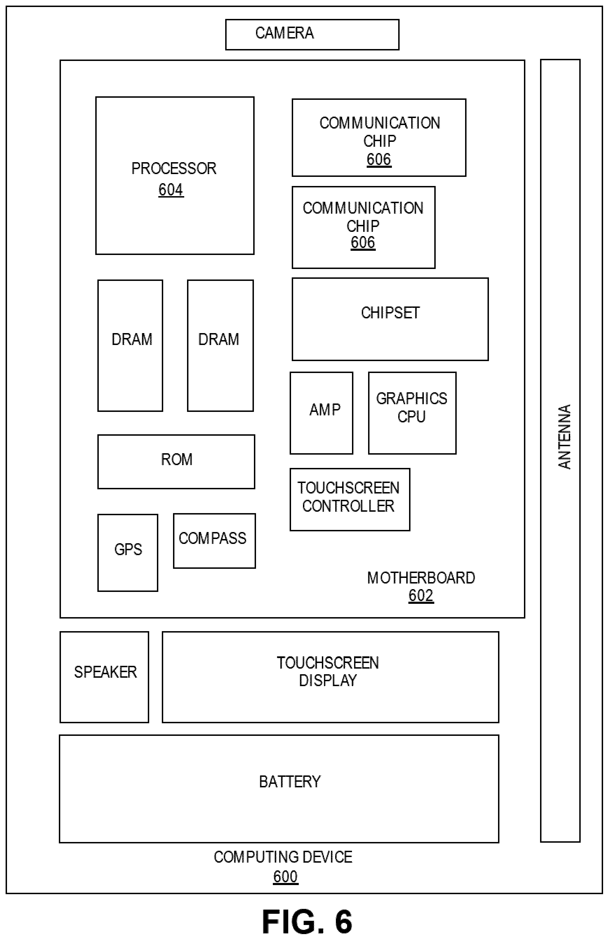

Figure 6 illustrates a computing device 600 in accordance with one implementation of an embodiment of the disclosure. The computing device 600 houses a board 602. The board 602 may include a number of components, including but not limited to a processor 604 and at least one communication chip 606. The processor 604 is physically and electrically coupled to the board 602. In some implementations the at least one communication chip 606 is also physically and electrically coupled to the board 602. In further implementations, the communication chip 606 is part of the processor 604.

Depending on its applications, computing device 600 may include other components that may or may not be physically and electrically coupled to the board 602. These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 606 enables wireless communications for the transfer of data to and from the computing device 600. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not. The communication chip 606 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 600 may include a plurality of communication chips 606. For instance, a first communication chip 606 may be dedicated to shorter range wireless communications such as Wi-Fi and Bluetooth and a second communication chip 606 may be dedicated to longer range wireless communications such as GPS, EDGE, GPRS, CDMA, WiMAX, LTE, Ev-DO, and others.

The processor 604 of the computing device 600 includes an integrated circuit die packaged within the processor 604. In an embodiment, the integrated circuit die of the processor may comprise a transistor with an IL between the semiconductor channel and the gate dielectric or ferroelectric gate oxide, as described herein. The term "processor" may refer to any device or portion of a device that processes electronic data from registers and/or memory to transform that electronic data into other electronic data that may be stored in registers and/or memory.

The communication chip 606 also includes an integrated circuit die packaged within the communication chip 606. In an embodiment, the integrated circuit die of the communication chip may comprise a transistor with an IL between the semiconductor channel and the gate dielectric or ferroelectric gate oxide, as described herein.

In further implementations, another component housed within the computing device 600 may comprise a transistor with an IL between the semiconductor channel and the gate dielectric or ferroelectric gate oxide, as described herein.

In various implementations, the computing device 600 may be a laptop, a netbook, a notebook, an ultrabook, a smartphone, a tablet, a personal digital assistant (PDA), an ultra mobile PC, a mobile phone, a desktop computer, a server, a printer, a scanner, a monitor, a set-top box, an entertainment control unit, a digital camera, a portable music player, or a digital video recorder. In further implementations, the computing device 600 may be any other electronic device that processes data.

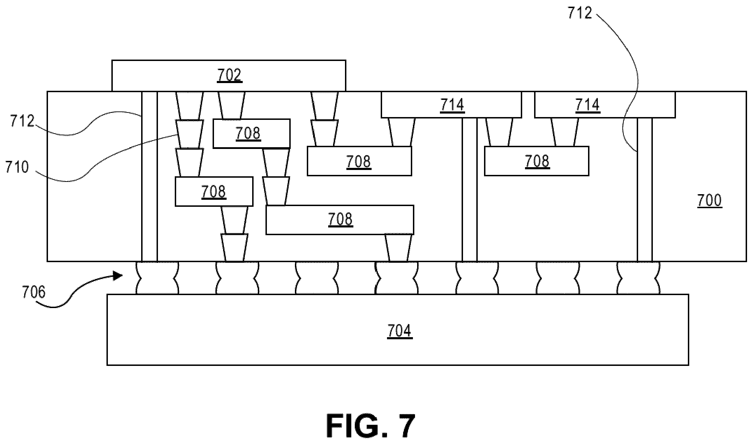

Figure 7 illustrates an interposer 700 that includes one or more embodiments of the disclosure. The interposer 700 is an intervening substrate used to bridge a first substrate 702 to a second substrate 704. The first substrate 702 may be, for instance, an integrated circuit die. The second substrate 704 may be, for instance, a memory module, a computer motherboard, or another integrated circuit die. In an embodiment, one of both of the first substrate 702 and the second substrate 704 may comprise a transistor with an IL between the semiconductor channel and the gate dielectric or ferroelectric gate oxide, in accordance with embodiments described herein. Generally, the purpose of an interposer 700 is to spread a connection to a wider pitch or to reroute a connection to a different connection. For example, an interposer 700 may couple an integrated circuit die to a ball grid array (BGA) 706 that can subsequently be coupled to the second substrate 704. In some embodiments, the first and second substrates 702/704 are attached to opposing sides of the interposer 700. In other embodiments, the first and second substrates 702/704 are attached to the same side of the interposer 700. And in further embodiments, three or more substrates are interconnected by way of the interposer 700.

The interposer 700 may be formed of an epoxy resin, a fiberglass-reinforced epoxy resin, a ceramic material, or a polymer material such as polyimide. In further implementations, the interposer 700 may be formed of alternate rigid or flexible materials that may include the same materials described above for use in a semiconductor substrate, such as silicon, germanium, and other group III-V and group IV materials.

The interposer 700 may include metal interconnects 708 and vias 710, including but not limited to through-silicon vias (TSVs) 712. The interposer 700 may further include embedded devices 714, including both passive and active devices. Such devices include, but are not limited to, capacitors, decoupling capacitors, resistors, inductors, fuses, diodes, transformers, sensors, and electrostatic discharge (ESD) devices. More complex devices such as radiofrequency (RF) devices, power amplifiers, power management devices, antennas, arrays, sensors, and MEMS devices may also be formed on the interposer 700. In accordance with embodiments of the disclosure, apparatuses or processes disclosed herein may be used in the fabrication of interposer 700.

Thus, embodiments of the present disclosure may comprise a transistor with an IL between the semiconductor channel and the gate dielectric or ferroelectric gate oxide.

The above description of illustrated implementations of embodiments of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize.

These modifications may be made to the disclosure in light of the above detailed description. The terms used in the following claims should not be construed to limit the disclosure to the specific implementations disclosed in the specification and the claims. Rather, the scope of the disclosure is to be determined entirely by the following claims, which are to be construed in accordance with established doctrines of claim interpretation.

Example 1: a transistor gate stack, comprising: a semiconductor channel; an interlayer (IL) over the semiconductor channel, wherein the IL has a thickness of 1nm or less and comprises zirconium; a gate dielectric over the IL; and a gate metal over the gate dielectric.

Example 2: the transistor gate stack of Example 1, wherein the IL further comprises oxygen.

Example 3: the transistor gate stack of Example 2, wherein the IL comprises a monolayer.

Example 4: the transistor gate stack of Example 3, wherein the IL has a thickness of 0.5nm or less.

Example 5: the transistor gate stack of Examples 1-4, wherein the gate stack is a planar gate stack.

Example 6: the transistor gate stack of Examples 1-4, wherein the gate stack is a non-planar gate stack.

Example 7: the transistor gate stack of Example 6, wherein the semiconductor channel is a fin, and wherein the IL is on a top surface of the fin and sidewall surfaces of the fin.

Example 8: the transistor gate stack of Example 6, wherein the semiconductor channel is a nanowire or a nanoribbon, and wherein the IL surrounds a perimeter of the nanowire or the nanoribbon.

Example 9: the transistor gate stack of Examples 1-8, wherein the semiconductor channel comprises silicon.

Example 10: the transistor gate stack of Examples 1-9, wherein the transistor gate stack is between a source region and a drain region.

Example 11: the transistor gate stack of Examples 1-10, wherein the gate dielectric is a high-k dielectric.

Example 12: the transistor gate stack of Examples 1-10, wherein the gate dielectric is a ferroelectric gate oxide.

Example 13: a method of forming a transistor gate stack, comprising: forming a first layer over a semiconductor channel, wherein the first layer comprises silicon and oxygen; forming a second layer over the first layer, wherein the second layer comprises zirconium; annealing the transistor gate stack, wherein the annealing results in the oxygen from the first layer desorbing and joining the zirconium to form a third layer comprising zirconium and oxygen; and disposing a gate dielectric over the third layer.

Example 14: the method of Example 13, wherein the second layer comprises one molar layer of the zirconium.

Example 15: the method of Example 13 or Example 14, wherein the first layer is formed with a UV-ozone treatment.

Example 16: the method of Example 15, wherein a thickness of the first layer is 1nm or less.

Example 17: the method of Examples 13-16, wherein a thickness of the third layer is 1nm or less.

Example 18: the method of Examples 13-16, wherein the annealing is at a temperature of 750°C or greater.

Example 19: the method of Examples 13-18, wherein the gate dielectric is a high-k dielectric.

Example 20: the method of Examples 13-18, wherein the gate dielectric is a ferroelectric gate oxide.

Example 21: the method of Examples 13-20, wherein the transistor gate stack is a planar gate stack.

Example 22: the method of Examples 13-20, wherein the transistor gate stack is a non-planar gate stack.

Example 23: an electronic system, comprising: a board; a package substrate coupled to the board; and a die coupled to the package substrate, wherein the die comprises a gate stack, comprising: a semiconductor channel; an interlayer (IL) over the semiconductor channel, wherein the IL has a thickness of 1nm or less, and wherein the IL comprises zirconium and oxygen; a gate dielectric over the IL; and a gate metal over the gate dielectric.

Example 24: the electronic system of Example 23, wherein the gate stack is a planar gate stack.

Example 25: the electronic system of Example 23, wherein the gate stack is a non-planar gate stack.

## Claims

1. A transistor gate stack, comprising:
a semiconductor channel;
an interlayer (IL) over the semiconductor channel, wherein the IL has a thickness of 1nm or less and comprises zirconium;
a gate dielectric over the IL; and
a gate metal over the gate dielectric.

2. The transistor gate stack of claim 1, wherein the IL further comprises oxygen.

3. The transistor gate stack of claim 2, wherein the IL comprises a monolayer.

4. The transistor gate stack of claim 3, wherein the IL has a thickness of 0.5nm or less.

5. The transistor gate stack of claim 1, 2, 3 or 4, wherein the gate stack is a planar gate stack.

6. The transistor gate stack of claim 1, 2, 3 or 4, wherein the gate stack is a non-planar gate stack.

7. The transistor gate stack of claim 6, wherein the semiconductor channel is a fin, and
wherein the IL is on a top surface of the fin and sidewall surfaces of the fin.

8. The transistor gate stack of claim 6, wherein the semiconductor channel is a nanowire or a nanoribbon, and wherein the IL surrounds a perimeter of the nanowire or the nanoribbon.

9. The transistor gate stack of claim 1, 2, 3, 4, 5, 6, 7 or 8, wherein the semiconductor channel comprises silicon.

10. The transistor gate stack of claim 1, 2, 3, 4, 5, 6,7 8, or 9, wherein the transistor gate stack is between a source region and a drain region.

11. The transistor gate stack of claim 1, 2, 3, 4, 5, 6, 7, 8, 9 or 10, wherein the gate dielectric is a high-k dielectric.

12. The transistor gate stack of claim 1, 2, 3, 4, 5, 6, 7, 8, 9 or 10, wherein the gate dielectric is a ferroelectric gate oxide.

13. A method of forming a transistor gate stack, comprising:
forming a first layer over a semiconductor channel, wherein the first layer comprises silicon and oxygen;
forming a second layer over the first layer, wherein the second layer comprises zirconium;
annealing the transistor gate stack, wherein the annealing results in the oxygen from the first layer desorbing and joining the zirconium to form a third layer comprising zirconium and oxygen; and
disposing a gate dielectric over the third layer.

14. The method of claim 13, wherein the second layer comprises one molar layer of the zirconium.

15. The method of claim 13 or 14, wherein the first layer is formed with a UV-ozone treatment.
